# EUROPÄISCHE PATENTSCHRIFT

(11) **EP 2 497 125 B1**
(45) Veröffentlichungstag und Bekanntmachung des Hinweises auf die Patenterteilung: **10.10.2018**
(21) Anmeldenummer: 11704207.7
(22) Anmeldetag: 10.02.2011
(51) Int. Cl.: H01L 33/38, H01L 33/02

(54) **HALBLEITERDIODE UND VERFAHREN ZUM HERSTELLEN EINER HALBLEITERDIODE**
SEMICONDUCTOR DIODE AND METHOD FOR PRODUCING A SEMICONDUCTOR DIODE
DIODE À SEMI-CONDUCTEURS ET PROCÉDÉ DE FABRICATION

(30) Priorität: 22.02.2010 DE 102010002204
(43) Veröffentlichungstag der Anmeldung: 12.09.2012
(73) Patentinhaber: OSRAM Opto Semiconductors GmbH, 93055 Regensburg (DE)
(72) Erfinder: ALBRECHT, Tony, 93077 Bad Abbach (DE); MAUTE, Markus, 93087 Alteglofsheim (DE); REUFER, Martin, 48734 Reken (DE); ZULL, Heribert, 93049 Regensburg (DE)
(74) Vertreter: Kanzian, Tanja
(86) Internationale Anmeldenummer: PCT/EP2011/051925
(87) Internationale Veröffentlichungsnummer: WO 2011/101280

(56) Entgegenhaltungen:
- DE-A1- 4 205 584
- JP-A- H0 864 872
- US-A- 5 663 581
- US-B1- 6 278 136

## Beschreibung

Die vorliegende Erfindung betrifft eine Halbleiterdiode und ein Verfahren zum Herstellen einer Halbleiterdiode.

Halbleiterdioden werden in vielfältigen Anwendungen eingesetzt. Eine besondere Anwendung ist eine LichtEmittierende Diode (LED).

Die LED ist ein Halbleiterbauelement, das mittels Elektrolumineszenz aus elektrischer Energie optische Strahlung, wie Licht, erzeugt. Dabei ist üblicherweise ein Halbleiter, beispielsweise ein III-V Halbleiter, vorgesehen. Es sind auf einem Substrat aufgewachsene Epitaxieschichten als Halbleiterschichtfolge möglich. Die Halbleiterschichtfolge enthält zur Erzeugung von elektromagnetischer Strahlung eine geeignete aktive Zone. Die aktive Zone kann ein pn-Übergang, eine Doppelheterostruktur oder eine Quantentopfstruktur wie eine Einfachquantentopfstruktur (SQW, *single quantum well*) oder Mehrfachquantentopfstruktur (MQW, *multi quantum well*) zur Strahlungserzeugung enthalten. Dokumente DE4205584 A1 und US6278136 B1 beschreiben LEDs mit Durchkontaktierungsbereichen, die durch eine Änderung des Leitungstyps hergestellt werden.

In einer LED ist es besonders wünschenswert, eine Strahlungsauskopplungsseite möglichst frei von Abschattungen zu halten, um eine gute Lichtauskopplung zu erzielen.

Der vorliegenden Erfindung liegt das Problem zugrunde, eine Halbleiterdiode bereitzustellen, die über eine einzige Seite der Halbleiterschichtfolge kontaktiert werden kann.

Dieses Problem wird durch eine Halbleiterdiode gemäß Patentanspruch 1 bzw. durch ein Verfahren zum Herstellen einer Halbleiterdiode gemäß Patentanspruch 7 gelöst.

Weiterbildungen und vorteilhafte Ausgestaltungen der lichtemittierenden Vorrichtung sind in den abhängigen Patentansprüchen angegeben.

### BEISPIELHAFTE AUSFÜHRUNGSFORMEN

Verschiedene Ausführungsformen der Halbleiterdiode haben eine erste Halbleiterschicht eines ersten Leitungstyps und eine zweite Halbleiterschicht eines zweiten Leitungstyps mit einer Dotierung. Die zweite Halbleiterschicht weist einen mit der ersten Halbleiterschicht verbundenen vertikalen Durchkontaktierungsbereich auf, in dem die Dotierung derart verändert ist, dass der Durchkontaktierungsbereich den ersten Leitungstyp aufweist.

Damit wird eine Halbleiterdiode bereitgestellt, deren beiden Halbleiterschichten von einer Seite der Halbleiterdiode kontaktierbar sind. Dies wird durch eine Veränderung der Dotierung in der zweiten Halbleiterschicht erzielt. Die zweite Halbleiterschicht als solche bleibt erhalten. Die planare Struktur, insbesondere der Durchkontaktierungsbereich, wird nicht mechanisch strukturiert, sondern die Dotierung in der zweiten Halbleiterschicht wird lokal verändert. Der Durchkontaktierungsbereich kann je nach gewünschter Struktur beliebig verändert werden.

Mit der Möglichkeit einer Kontaktierung der Halbleiterdiode über die Seite der zweiten Halbleiterschicht kann die Seite der ersten Halbleiterschicht frei von Kontaktelemente gehalten werden. Dies ist besonders vorteilhaft in Zusammenhang mit einer LED, weil dadurch die Seite der ersten Halbleiterschicht als Strahlungsauskopplungsseite dienen kann, ohne dass abschattende Kontaktelemente vorgesehen sein müssen. Weiterhin können damit andere Gehäuse, wie beispielsweise ein sogenanntes *wafer level package,* oder auch Multichipgehäuse, wie sogenannte *system-in-package,* in denen die Halbleiterdiode auf ein weiteres Halbleiterbauelement aufgebracht ist, verwendet werden. So kann beispielsweise eine LED auf einem Halbleiterbauelement aufgebracht sein, das eine Treiberschaltung enthält, und sowohl die Treiberschaltung als auch die LED in einem Gehäuse untergebracht sein.

Ein wesentlicher Vorteil der Halbleiterdiode ergibt sich in einer einfachen Prozessführung bei der Erzeugung des Durchkontaktierungsbereichs. Dieser wird durch eine lokale Veränderung der Dotierung der zweiten Halbleiterschichtfolge erzeugt. Damit entfallen aufwändige Prozessführungsschritte, wie sie beispielsweise aus dem Dokument [1] bei der Herstellung von sogenannten Via-Strukturen als Durchkontaktierung bekannt sind. Vor allem entfällt bei Herstellung der beschriebenen Halbleiterdiode das Ätzen von Strukturen. Die Prozessierung ist durch weniger lithographische Schritte und durch weniger folgende Prozessschritte zur Ausgleichung topographischer Unterschiede vereinfacht. Damit kann auf einfache und kostengünstige Art eine Halbleiterdiode bereitgestellt werden, deren eine Seite frei von Kontaktelementen ist.

In einigen Ausführungsformen entspricht der erste Leitungstyp einer n-Dotierung und der zweite Leitungstyp entspricht einer p-Dotierung. Dabei ist besonders vorteilhaft, dass sich gerade eine p-Dotierung leicht verändern, bzw. zerstören lässt.

In einigen Ausführungsformen ist die erste Halbleiterschicht über den Durchkontaktierungsbereich und einen ersten Kontakt elektrisch kontaktiert. Die zweite Halbleiterschicht ist von einem zweiten Kontakt elektrisch kontaktiert.

In einigen Ausführungsformen ist der Durchkontaktierungsbereich durch eine lokale Schädigung der Dotierung in der zweiten Halbleiterschicht erzeugt. Die Schädigung kann durch eine Vielzahl von Verfahren hervorgerufen werden. Diese sind beispielsweise: Ionenimplantation, Ionenbeschuss (im Fall eines Galliumnitrid (GaN)-Halbleiters beispielsweise mit Argon-(Ar-)Ionen), das Einbringen von Defekten bzw. Störstellen in den Halbleiter oder eine elektrische Passivierung durch das Einbringen von Wasserstoff in den Halbleiter. Letzteres kann beispielsweise durch das Aussetzen gegenüber einem Plasma oder durch ein Tempern in einer Wasserstoffatmosphäre erfolgen. Die genannten Eingriffe wirken sich dabei direkt auf die Dotierung oder auf die Ladungsträger in der zweiten Halbleiterschicht aus. Entscheidend ist jedoch, dass die Diodencharakteristik des pn-Übergangs lokal im Durchkontaktierungsbereich zerstört ist.

In einigen Ausführungsformen, die nicht zum Gegenstand der Erfindung wie beansprucht gehören, ist der Durchkontaktierungsbereich entlang einer Seitenfläche der zweiten Halbleiterschicht angeordnet. Dadurch ist die Diodencharakteristik entlang einer Seitenfläche der Halbleiterdiode zerstört. In diesem Bereich fällt damit kein elektrisches Potential ab, insbesondere kann damit kein durch ein elektrisches Feld hervorgerufener Ionentransport hervorgerufen werden. In den Ausführungsformen, der Erfindung wie beansprucht, verläuft der Durchkontaktierungsbereich umlaufend entlang der Seitenflächen der zweiten Halbleiterschicht.

In einigen Ausführungsformen ist die Halbleiterdiode als optoelektronische Diode, bspw. als LED eingerichtet.

In einigen Ausführungsformen ist die Halbleiterdiode als Dünnschichthalbleiterbauelement eingerichtet.

Verschiedene Ausführungsformen des Verfahrens zum Herstellen einer Halbleiterdiode umfassen:
- Bereitstellen einer ersten Halbleiterschicht von einem ersten Leitfähigkeitstyp;
- Bereitstellen einer zweiten Halbleiterschicht von einem zweiten Leitfähigkeitstyp;
- lokales Verändern einer Dotierung der zweiten Halbleiterschicht, so dass in der zweiten Halbleiterschicht ein Durchkontaktierungsbereich zum Kontaktieren der ersten Halbleiterschicht erzeugt wird.

Durch das Verfahren wird auf eine einfache und effiziente Art eine Halbleiterdiode bereitgestellt, die lediglich von der Seite der zweiten Halbleiterschicht kontaktiert werden braucht.

In einigen Ausführungsformen zum Verändern der Dotierung der zweiten Halbleiterschicht wird diese geschädigt. In einigen Ausführungsbeispielen wird die Schädigung durch einen der folgenden Prozessen, oder einer Kombination einzelner dieser Prozesse hervorgerufen:
- Ionenimplantation,
- Ionenbeschuss (im Fall eines Galliumnitrid (GaN)-Halbleiters beispielsweise mit Argon-(Ar-)Ionen),
- Einbringen von Defekten bzw. Störstellen in den Halbleiter oder
- elektrische Passivierung durch das Einbringen von Wasserstoff in die zweite Halbleiterschicht, beispielsweise durch das Aussetzen gegenüber einem Plasma oder durch ein Tempern in einer Wasserstoffatmosphäre.

### KURZE BESCHREIBUNG DER ZEICHNUNGEN

Verschiedene Ausführungsbeispiele der Halbleiterdiode und des Verfahrens zum Herstellen einer Halbleiterdiode werden im Folgenden anhand der Zeichnungen näher erläutert. In den Figuren geben die erste(n) Ziffer(n) eines Bezugszeichens die Figur an, in denen das Bezugszeichen zuerst verwendet wird. Die gleichen Bezugszeichen werden für gleichartige oder gleich wirkende Elemente bzw. Eigenschaften in allen Figuren verwendet.

Es zeigen:
- **Fig. 1**: den schematischen Querschnitt durch ein erstes Ausführungsbeispiel einer Halbleiterdiode;
- **Fig. 2**: den schematischen Querschnitt durch ein zweites Ausführungsbeispiel einer Halbleiterdiode;
- **Fig. 3**: den schematischen Aufbau einer Kontaktseite der zweiten Halbleiterschicht eines dritten Ausführungsbeispiels einer Halbleiterdiode und
- **Fig. 4**: den schematischen Ablauf eines Verfahrens zum Herstellen einer Halbleiterdiode.

### DETAILLIERTE BESCHREIBUNG DER ZEICHNUNGEN

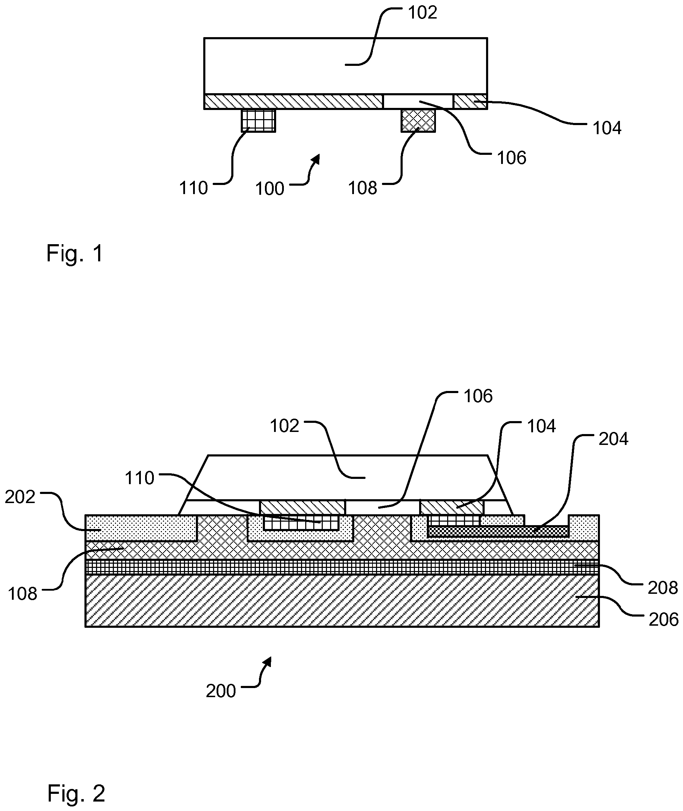

**Fig. 1** zeigt den schematischen Querschnitt durch ein erstes Ausführungsbeispiel einer Halbleiterdiode 100. Die Halbleiterdiode 100 weist eine Halbleitschichtfolge auf, die eine erste Halbleiterschicht 102 und eine zweite Halbleiterschicht 104 umfasst. Die Halbleiterschichtfolge ist beispielsweise durch ein Dünnschichtverfahren hergestellt worden. Dieses ist beispielsweise in dem Dokument [2] oder dem Dokument [3] beschrieben, deren Offenbarung hiermit durch Rückbezug aufgenommen wird. Die erste Halbleiterschicht 102 weist durch eine Dotierung mit einem ersten Dotiermaterial einen ersten Leitungstyp auf. In dem ersten Ausführungsbeispiel ist die erste Halbleiterschicht 102 ein n-dotierter Halbleiter, bspw. ein mit Si dotierter GaN-Halbleiter. Die zweite Halbleiterschicht 104 weist durch eine Dotierung mit einem zweiten Dotiermaterial einen zweiten Leitungstyp auf. In dem zweiten Ausführungsbeispiel ist die zweite Halbleiterschicht ein p-dotierter Halbleiter, bspw. ein mit Magnesium (Mg) dotierter GaN-Halbleiter.

Um die erste Halbleiterschicht 102 über die Seite der zweiten Halbleiterschicht 104 kontaktieren zu können, weist die zweite Halbleiterschicht 104 wenigstens einen Durchkontaktierungsbereich 106 auf, in dem die Dotierung der zweiten Halbschicht 104 mit dem zweiten Dotiermaterial verändert ist. Dies geschieht beispielsweise durch einen lokalen Plasmaprozess, der auf den Durchkontaktierungsbereich 106 einwirkt. Beispielsweise wird die zweite Halbleiterschicht 102 in dem Durchkontaktierungsbereich 106 einem beliebigen Plasma, bspw. einem Ar-Plasma, ausgesetzt. Durch das Plasma wird die Dotierung der zweiten Halbleiterschicht 104 geschädigt. Die Schädigung kann ebenfalls durch eine Vielzahl von weiteren Verfahren hervorgerufen werden. Diese sind beispielsweise: Ionenimplantation, Ionenbeschuss (im Fall des GaN-Halbleiters beispielsweise mit Ar-Ionen), das Einbringen von Defekten bzw. Störstellen in die zweite Halbleiterschicht 104 oder eine elektrische Passivierung durch das Einbringen von Wasserstoff in die zweite Halbleiterschicht 104. Letzteres kann beispielsweise durch ein lokales Aussetzen der zweiten Halbleiterschicht 104 gegenüber einem Plasma oder durch ein Tempern in einer Wasserstoffatmosphäre erfolgen. Die genannten Eingriffe wirken sich dabei direkt auf die Dotierung oder auf die Ladungsträger in der zweiten Halbleiterschicht 104 aus. Entscheidend ist jedoch, dass die Diodencharakteristik des pn-Übergangs lokal im Durchkontaktierungsbereich 106 zerstört ist. Im Umfeld der Störstellen stehen mehr Donatoren bzw. Ladungsträger zur Verfügung, so dass in der p-leitenden zweiten Halbleiterschicht 104 ein n-leitender Durchkontaktierungsbereich 106 hergestellt ist.

Damit kann die gesamte Halbleiterdiode 100 von der Seite der zweiten Halbleiterschicht 104 kontaktiert werden. Dazu ist ein erster Kontaktanschluss 108 an den Durchkontaktierungsbereich 106 angeschlossen. Ein zweiter Kontaktanschluss 110 ist unmittelbar an die zweite Halbleiterschicht 104 angeschlossen. Es erweist sich insbesondere als vorteilhaft, dass der durch eine Schädigung erzeugte Durchkontaktierungsbereich 106 in lateraler Richtung einen hochohmigen Übergang zu der nicht geschädigten zweiten Halbleiterschicht 104 aufzeigt. Ein lateraler bzw. transversaler Ladungsträgertransport findet kaum statt, so dass der überwiegende Teil eines über den Durchkontaktierungsbereich 106 eingebrachten Stroms der ersten Halbleiterschicht 102 zugeführt wird. Damit ist es nicht notwendig, zwischen dem Durchkontaktierungsbereich 106 und der nicht geschädigten zweiten Halbleiterschicht 104 eine besondere elektrische Isolation vorzusehen. Weiterhin kann so bei einer lichtemittierenden Halbleiterdiode 100 insbesondere ein homogenes Leuchtbild erreicht werden.

**Fig. 2** zeigt den schematischen Querschnitt durch ein zweites Ausführungsbeispiel einer Halbleiterdiode 200. Die Halbleiterdiode 200 hat einen aus einer Halbleiterschichtfolge bestehenden Halbleiterkörper. Der Halbleiterkörper stellt eine Mesastruktur dar. Die Halbleiterschichtfolge umfasst eine erste Halbleiterschicht 102 und eine zweite Halbleiterschicht 104. Die erste Halbleiterschicht 102 ist dabei ein wie im ersten Ausführungsbeispiel beschriebenes n-dotiertes Halbleitermaterial. Die zweite Halbleiterschicht 104 ist dabei ein wie im ersten Ausführungsbeispiel beschriebenes p-dotiertes Halbleitermaterial.

Um die erste Halbleiterschicht 102 über die Seite der zweiten Halbleiterschicht 104 kontaktieren zu können, weist die zweite Halbleiterschicht 104 wenigstens einen Durchkontaktierungsbereich 106 auf, in dem die Dotierung der zweiten Halbschicht 104 mit dem zweiten Dotiermaterial verändert ist. Dies geschieht beispielsweise durch einen lokalen Plasmaprozess, der auf den Durchkontaktierungsbereich 106 einwirkt. Beispielsweise wird die zweite Halbleiterschicht 102 in dem Durchkontaktierungsbereich 106 einem beliebigen Plasma, beispielsweise einem Argon-(Ar-) Plasma, ausgesetzt. Durch das Plasma wird die Dotierung der zweiten Halbleiterschicht 104 geschädigt, insbesondere werden in das Halbleitermaterial Störstellen eingebracht. Im Umfeld der Störstellen stehen mehr Donatoren zur Verfügung, so dass in der p-leitenden zweiten Halbleiterschicht 104 ein n-leitender Durchkontaktierungsbereich 106 hergestellt ist.

Der Halbleiterkörper ist auf einer Anschlussstruktur aufgebracht. Die Anschlussstruktur weist einen ersten Kontakt 108 auf, der mit dem Durchkontaktierungsbereich 106 elektrisch verbunden ist. Der erste Kontakt 108 ist in aller Regel ein guter elektrischer Leiter, wie bspw. eine Metallschicht. Zugleich dient der erste Kontakt 108 als Spiegel für in dem Halbleiterkörper erzeugte elektromagnetische Strahlung, um eine höhere Effizienz der Strahlungsauskopplung über die der Anschlussstruktur gegenüberliegende Seite des Halbleiterkörpers (der "n-Seite") zu erhalten. Der erste Kontakt 108 besteht daher aus einem die Strahlung gut reflektierenden Leiter, wie beispielsweise Silber (Ag) oder einer silberhaltigen Legierung.

Weiterhin weist die Anschlussstruktur einen zweiten Kontakt 110 auf, der mit der zweiten Halbleiterschicht 104 elektrisch verbunden ist. Der zweite Kontakt 110 ist wie der erste Kontakt 108 ein guter elektrischer Leiter, wie bspw. eine Metallschicht. Der zweite Kontakt 110 dient ebenfalls als Spiegel zur Steigerung der Strahlungsauskopplung über die n-Seite. Er besteht daher ebenfalls aus einem die Strahlung gut reflektierenden Leiter, wie beispielsweise Silber (Ag) oder einer silberhaltigen Legierung. Um einen Kurzschluss zu vermeiden, sind der erste Kontakt 108 und der zweite Kontakt 110 durch ein Dielektrikum 202 voneinander elektrisch isoliert. Das Dielektrikum enthält beispielsweise Siliziumdioxid (SiO₂) oder Siliziumnitrid (SiN) oder besteht aus einem dieser Materialien. Es kann gleichzeitig als Passivierung des ersten Kontakts 108 und des zweiten Kontakts 110 dienen. Damit wird eine Degradation der Kontakte, beispielsweise durch Oxidation und Ionenmigration, vermieden.

Zur Kontaktierung der Kontakte werden Kontaktanschlüsse bzw. sogenannte *bondpads* vorgesehen, über die mittels eines Bonddrähtchens oder anderer geeigneter elektrischer Verbindungen ein elektrischer Kontakt hergestellt wird. Beispielsweise ist ein Kontaktanschluss 204 für eine elektrische Kontaktierung zum zweiten Kontakt 110 vorgesehen. Das Bondpad 204 besteht aus einem elektrischen Leiter, der möglichst inert gegenüber äußeren Einflüssen ist, und der sich leicht, bspw. über eine Lötverbindung, an eine elektrische Verbindung anschließen lässt. Geeignete Materialien sind beispielsweise Gold (Au), Platin (Pt) oder Titan (Ti), bzw. Legierungen, die eines oder mehrere dieser Materialien enthalten.

Der Halbleiterkörper wird zusammen mit der Anschlussstruktur auf einen Träger 206 aufgebracht. Sie sind mit dem Träger 206 über ein Verbindungslot 208 befestigt. Das Verbindungslot 208 weist ein niederschmelzendes Metall oder eine niederschmelzende Metalllegierung auf.

Der Durchkontaktierungsbereich 106 verläuft längs der Auskanten der Mesa-Seitenflächen (Mesa-Flanken) des Halbleiterkörpers. Dadurch sind an den Seitenflächen keine Kontaktflächen zwischen einem n-dotierten und einem p-dotierten Halbleitergebiet vorhanden. Durch den fehlenden p-n-Übergang an den Außenseiten werden insbesondere Effekte wie eine Migration von Ag⁺-Ionen aus dem zweiten Kontakt 110 in den Halbleiterkörper verhindert. Die Migration des in dem zweiten Kontakt 110 enthaltenden Materials entsteht durch ein äußeres elektrisches Feld, wobei sich Ionen eines Metalls entlang der Feldlinien des Feldes bewegen. Dadurch können Ionen beispielsweise in den Halbleiterkörper gelangen und dort Schaden verursachen, indem sie beispielsweise die elektrischen Eigenschaften einer Halbleiterschichtfolge verändern.

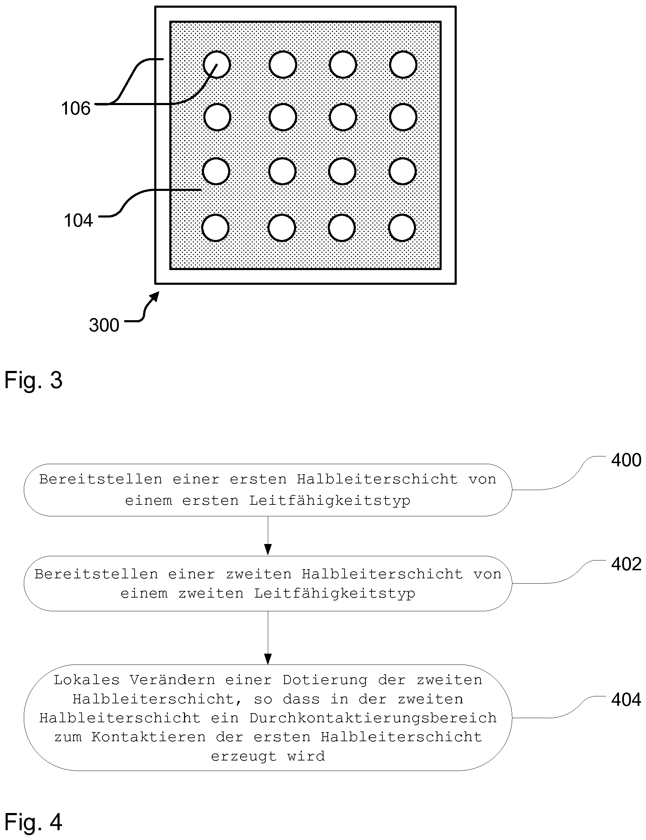

**Fig. 3** zeigt den schematischen Aufbau einer Kontaktseite 300 der zweiten Halbleiterschicht eines dritten Ausführungsbeispiels einer Halbleiterdiode. Die Kontaktseite 300 umfasst eine Seite der zweiten Halbleiterschicht 104. In der zweiten Halbleiterschicht 104 sind mehrere Durchkontaktierungsbereiche 106 durch eine Schädigung der Dotierung der zweiten Halbleiterschicht 104 eingebracht. Die Durchkontaktierungsbereiche 106 verlaufen umlaufend entlang der Außenseite der Kontaktseite 300. Zudem ist eine Vielzahl voneinander getrennt angeordneter einzelner Durchgangsbereiche 106 vorgesehen. Durch die Größe und die Anordnung der Durchgangsbereiche kann eine Bestromung und damit beispielsweise eine Leuchtdichte der Halbleiterdiode beeinflusst werden. Neben der dargestellten Anordnung in einer quadratischen Netzstruktur sind beispielsweise auch Anordnung in hexagonalen Strukturen oder andere geeignete Strukturen denkbar.

**Fig. 4** zeigt den schematischen Ablauf eines Verfahrens zum Herstellen einer Halbleiterdiode.

Dabei wird in einem ersten Verfahrensschritt 400, beispielsweise durch ein epitaktisches Aufwachens, eine erste Halbleiterschicht von einem ersten Leitfähigkeitstyp bereitgestellt. In einem zweiten Verfahrensschritt 402 wird, beispielsweise durch ein epitaktisches Aufwachsen auf der ersten Halbleiterschicht, eine zweite Halbleiterschicht von einem zweiten Leitfähigkeitstyp bereitgestellt. Die erste Halbleiterschicht kann dabei beispielsweise ein n-dotierter Halbleiter sein, während die zweite Halbleiterschicht ein p-dotierter Halbleiter ist. In anderen Ausführungsformen werden zunächst die zweite Halbleiterschicht und anschließend die erste Halbleiterschicht bereitgestellt.

In einem dritten Verfahrensschritt 404 wird eine Dotierung der zweiten Halbleiterschicht lokal verändert, so dass in der zweiten Halbleiterschicht ein Durchkontaktierungsbereich zum Kontaktieren der ersten Halbleiterschicht erzeugt wird. Das Verändern der Dotierung kann bereits vor einem Bereitstellen der ersten Halbleiterschicht erfolgen.

Zum Verändern der Dotierung der zweiten Halbleiterschicht kann diese geschädigt werden. Die Schädigung kann durch eine Vielzahl von Prozessen erfolgen. Dazu gehören beispielsweise:
- Ionenimplantation,
- Ionenbeschuss (im Fall eines Galliumnitrid (GaN)-Halbleiters beispielsweise mit Argon-(Ar-)Ionen),
- Einbringen von Defekten bzw. Störstellen in den Halbleiter oder
- elektrische Passivierung durch das Einbringen von Wasserstoff in die zweite Halbleiterschicht, beispielsweise durch das Aussetzen gegenüber einem Plasma oder durch ein Tempern in einer Wasserstoffatmosphäre.

### ABSCHLIESSENDE FESTSTELLUNG

Die Halbleiterdiode und das Verfahren zum Herstellen einer Halbleiterdiode wurde zur Veranschaulichung des zugrundeliegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso möglich, in Ausführungsbeispielen einzelne dargestellte Merkmale oder besondere Ausgestaltungen wegzulassen oder hinzuzufügen, soweit die allgemeine technische Lehre realisiert bleibt.

### LITERATUR

In diesem Dokument sind die folgenden Veröffentlichungen zitiert:
[1] DE 10 2008 051048;
[2] EP 0 905 797 A2 und
[3] WO 02/13281 A1.

**BEZUGSZEICHENLISTE**

| | |
|---|---|
| Halbleiterdiode | 100 |
| Erste Halbleiterschicht | 102 |
| Zweite Halbleiterschicht | 104 |
| Durchkontaktierungsbereich | 106 |
| Erster Kontakt | 110 |
| Zweiter Kontakt | 112 |
| Halbleiterdiode | 200 |
| Dielektrikum | 202 |
| Kontaktanschluss | 204 |
| Träger | 206 |
| Verbindungslot | 208 |
| Kontaktseite | 300 |
| Erster Verfahrensschritt | 400 |
| Zweiter Verfahrensschritt | 402 |
| Dritter Verfahrensschritt | 404 |
| Halbleiterdiode | 100 |
| Erste Halbleiterschicht | 102 |
| Zweite Halbleiterschicht | 104 |
| Durchkontaktierungsbereich | 108 |
| Erster Kontakt | 110 |
| Zweiter Kontakt | 112 |
| Halbleiterdiode | 200 |
| Dielektrikum | 202 |
| Kontaktanschluss | 204 |
| Träger | 206 |
| Verbindungslot | 208 |
| Kontaktseite | 300 |
| Erster Verfahrensschritt | 400 |
| Zweiter Verfahrenschritt | 402 |
| Dritter Verfahrensschritt | 404 |

## Patentansprüche

1. Halbleiterdiode umfassend:
einen Halbleiterkörper mit
- einer ersten Halbleiterschicht in Form einer Mesastruktur (102) eines ersten Leitungstyps und
- einer zweiten Halbleiterschicht (104) eines zweiten Leitungstyps mit einer Dotierung,
wobei die zweite Halbleiterschicht einen mit der ersten Halbleiterschicht verbundenen vertikalen Durchkontaktierungsbereich (106) aufweist, in dem die Dotierung derart verändert ist, dass der Durchkontaktierungsbereich (106) den ersten Leitungstyp aufweist,
charakterisiert dadurch, dass der
Durchkontaktierungsbereich (106) längs der Außenseiten der Mesa-Seitenflächen des Halbleiterkörpers verläuft.

2. Halbleiterdiode gemäß Patentanspruch 1,
wobei der erste Leitungstyp einer n-Dotierung entspricht und der zweite Leitungstyp einer p-Dotierung entspricht.

3. Halbleiterdiode gemäß einem der vorangehenden Patentansprüche,
wobei die erste Halbleiterschicht (102) über den Durchkontaktierungsbereich (106) und einen ersten Kontakt (108) elektrisch kontaktiert ist und
die zweite Halbleiterschicht (104) von einem zweiten Kontakt (110) elektrisch kontaktiert ist.

4. Halbleiterdiode gemäß einem der vorangehenden Patentansprüche,
wobei der Durchkontaktierungsbereich (106) durch eine lokale Schädigung der Dotierung in der zweiten Halbleiterschicht (104) erzeugt ist.

5. Halbleiterdiode gemäß einem der vorangehenden Patentansprüche,
die als optoelektronische Diode eingerichtet ist.

6. Halbleiterdiode gemäß einem der vorangehenden Patentansprüche,
die als Dünnschichthalbleiterbauelement eingerichtet ist.

7. Verfahren zum Herstellen einer Halbleiterdiode umfassend:
- Bereitstellen einer ersten Halbleiterschicht von einem ersten Leitfähigkeitstyp;
- Bereitstellen einer zweiten Halbleiterschicht von einem zweiten Leitfähigkeitstyp;
- Bereitstellen eines Halbleiterkörpers in Form einer Mesastruktur;
- lokales Verändern einer Dotierung der zweiten Halbleiterschicht, so dass in der zweiten Halbleiterschicht ein Durchkontaktierungsbereich zum Kontaktieren der ersten Halbleiterschicht erzeugt wird, charakterisiert dadurch, dass der Durchkontaktierungsbereich (106) längs der Außenseiten der Mesa-Seitenflächen des Halbleiterkörpers verläuft.

8. Verfahren gemäß Patentanspruch 7 umfassend:
- Schädigung der Dotierung der zweiten Halbleiterschicht zum Verändern der Dotierung.

9. Verfahren gemäß Patentanspruch 8 wobei die Schädigung durch einen der folgenden Prozessen, oder einer Kombination einzelner dieser Prozesse hervorgerufen wird:
- Ionenimplantation,
- Ionenbeschuss,
- Einbringen von Defekten in die zweite Halbleiterschicht, oder
- elektrische Passivierung durch das Einbringen von Wasserstoff in die zweite Halbleiterschicht.

## Claims

1. Semiconductor diode comprising:
a semiconductor body having
- a semiconductor layer in the form of a mesa structure (102) of a first conduction type, and
- a second semiconductor layer (104) of a second conduction type having a doping,
wherein the second semiconductor layer has a vertical via region (106) connected to the first semiconductor layer, in which via region the doping is altered in such a way that the via region (106) has the first conduction type,
**characterized in that** the via region (106) extends along the outer sides of the mesa side surfaces of the semiconductor body.

2. Semiconductor diode according to Patent Claim 1,
wherein the first conduction type corresponds to an n-type doping and the second conduction type corresponds to a p-type doping.

3. Semiconductor diode according to either of the preceding patent claims,
wherein the first semiconductor layer (102) is electrically contacted by means of the via region (106) and a first contact (108), and
the second semiconductor layer (104) is electrically contacted by a second contact (110).

4. Semiconductor diode according to any of the preceding patent claims,
wherein the via region (106) is produced by a local damage of the doping in the second semiconductor layer (104).

5. Semiconductor diode according to any of the preceding patent claims,
which is configured as an optoelectronic diode.

6. Semiconductor diode according to any of the preceding patent claims,
which is configured as a thin-film semiconductor component.

7. Method for producing a semiconductor diode comprising:
- providing a first semiconductor layer of a first conductivity type;
- providing a second semiconductor layer of a second conductivity type;
- providing a semiconductor body in the form of a mesa structure;
- locally altering a doping of the second semiconductor layer, such that a via region for contacting the first semiconductor layer is produced in the second semiconductor layer, **characterized in that** the via region (106) extends along the outer sides of the mesa side surfaces of the semiconductor body.

8. Method according to Patent Claim 7 comprising:
- damaging the doping of the second semiconductor layer for the purpose of altering the doping.

9. Method according to Patent Claim 8, wherein the damaging is brought about by one of the following processes, or a combination of individual processes from among these processes:
- ion implantation,
- ion bombardment,
- introducing defects into the second semiconductor layer, or
- electrical passivation by introducing hydrogen into the second semiconductor layer.

## Revendications

1. Diode à semi-conducteurs comprenant :
un corps de semi-conducteur avec
- une première couche de semi-conducteur (102) sous forme d'une mésastructure (102) d'un premier type de conduction et
- une deuxième couche de semi-conducteur (104) d'un deuxième type de conduction avec un dopage,
dans laquelle la deuxième couche de semi-conducteur présente une zone de mise en contact traversante (106) verticale reliée à la première couche de semi-conducteur dans laquelle le dopage est ainsi modifié que la zone de mise en contact traversante (106) présente le premier type de conduction,
**caractérisé en ce que** la zone de mise en contact traversante (106) passe le long des côtés extérieurs des mésa faces latérales du corps de semi-conducteur.

2. Diode à semi-conducteurs selon la revendication 1, dans laquelle le premier type de conduction correspond à un dopage N et le deuxième type de conduction correspond à un dopage P.

3. Diode à semi-conducteurs selon l'une des revendications précédentes, dans laquelle la première couche de semi-conducteur (102) est mise en contact électrique par la zone de mise en contact traversante (106) et un premier contact (108) et
la deuxième couche de semi-conducteur (104) est mise en contact électrique par un deuxième contact (110).

4. Diode à semi-conducteurs selon l'une des revendications précédentes, dans laquelle la zone de mise en contact traversante (106) est produite par une détérioration locale du dopage dans la deuxième couche de semi-conducteur (104) .

5. Diode à semi-conducteurs selon l'une des revendications précédentes, qui est agencée en tant que diode optoélectronique.

6. Diode à semi-conducteurs selon l'une des revendications précédentes, qui est conçue en tant que composant de semi-conducteur à couche mince.

7. Procédé de fabrication d'une diode à semi-conducteurs comprenant :
- la fourniture d'une première couche de semi-conducteur d'un premier type de conductivité ;
- la fourniture d'une deuxième couche de semi-conducteur d'un deuxième type de conductivité ;
- la fourniture d'un corps de semi-conducteur sous forme d'une mésastructure ;
- une modification locale d'un dopage de la deuxième couche de semi-conducteur de manière à ce qu'une zone de mise en contact est créée dans la deuxième couche de semi-conducteur pour la mise en contact avec la première couche de semi-conducteur, **caractérisé en ce que** la zone de mise en contact traversante (106) passe le long des côtés extérieurs des mésa faces latérales du corps de semi-conducteur.

8. Procédé selon la revendication 7 comprenant :
- la détérioration du dopage de la deuxième couche de semi-conducteur pour modifier le dopage.

9. Procédé selon la revendication 8, dans lequel la détérioration est effectuée par un des procédés suivants ou une combinaison de ces procédés individuels :
- implantation ionique,
- bombardement ionique
- introduction de défauts dans la deuxième couche de semi-conducteur,
ou
- passivation électrique par introduction d'hydrogène dans la deuxième couche de semi-conducteur.
